# EUROPEAN PATENT APPLICATION

(11) **EP 4 280 236 A1**
(43) Date of publication of application: **22.11.2023**
(21) Application number: 22173649.9
(22) Date of filing: 16.05.2022
(51) Int. Cl.: H01F 27/28, H01F 27/29, H01F 27/26, H05K 1/18, H01F 27/06

(54) **WOUND CORE CIRCUIT COMPONENT**

(71) Applicant: Goodrich Control Systems, West Midlands B90 4SS (GB)
(72) Inventor: McLean, Andrew, Halesowen B62 8TR (GB)
(74) Representative: Dehns

(57) **Abstract**

A wound core component (16) comprises a wound core (20) comprising a core (21) and a wire (22) wound around at least a portion of the core (21), and a carrier circuit board (24) comprising a substrate layer and a through-hole (26) formed through the substrate layer. The wound core (20) is fixed to the carrier circuit board (24). The wound core component (16) comprises a threaded insert (28) for receiving a corresponding threaded fixing (36), the threaded insert (28) fixedly received into the through-hole (26) of the carrier circuit board (24).

## Description

### TECHNICAL FIELD

The present disclosure relates to a wound core circuit component, particularly a toroidal core for a power supply for use in an aircraft.

### BACKGROUND

Wound cores are circuit components having a magnetic core surrounded by windings of wire. Wound cores are used as inductors and transformers in a variety of electrical applications, including in power supplies and in AC/DC inverters.

When wound core components are used on printed circuit boards (PCBs), they must often be securely attached onto the circuit board, and terminals connected using a soldering process. The mechanical securing process can be challenging in an electronics manufacturing environment more suited to high volume soldering processes. It can also be time consuming and prone to faults, and is particularly vulnerable to field failures in the connection between the wound core component and the circuit board.

Wound core components can be subject to harsh mechanical environments with significant vibration levels. One particularly difficult environment requiring the use of wound core components is in aircraft systems, and particularly in an electronic control unit for a switch-mode power supply; switch-mode power supplies are often used in such systems to save vital space and weight as compared to linear power supplies.

### SUMMARY

Accordingly, it is an object of the present disclosure to provide a more robust means of attaching and connecting a wound core component to a main circuit board, so as to prevent mechanical failures or detachment from the main circuit board. It is also an object of the present invention to simplify the manufacturing processes involved in manufacturing the assembly in order to reduce manufacturing time and reduce the costs involved.

According to a first aspect of the present disclosure, there is provided a wound core component comprising a wound core comprising a core and a wire wound around at least a portion of the core, a carrier circuit board comprising a substrate layer and a through-hole formed through the substrate layer, wherein the wound core is fixed to the carrier circuit board, and a threaded insert for receiving a corresponding threaded fixing, the threaded insert fixedly received into the through-hole of the carrier circuit board.

In a further embodiment of the above, the wound core is a toroidal core.

In a further embodiment of any of the above, the wound core comprises an inductor or a transformer.

In a further embodiment of any of the above, the threaded insert is attached to the carrier circuit board by soldering.

In a further embodiment of any of the above, the through-hole comprises a plating formed of a solderable material, and the threaded insert is soldered to the plating.

In a further embodiment of any of the above, the through-hole defines a central axis which is coaxial with a central axis defined by the wound core.

In a further embodiment of any of the above, the carrier circuit board comprises a plurality of conductive elements and the wire of the wound core is soldered to the plurality of conductive elements.

In a further embodiment of any of the above, the plurality of conductive elements comprise circuit traces of the carrier circuit board.

According to a further aspect of the present disclosure, there is provided a circuit board assembly comprising a main circuit board, a wound core component according to any of the above, the carrier circuit board of the wound core component received on the main circuit board, and a threaded fixing received into the threaded insert to secure the wound core component to the main circuit board.

In a further embodiment of the above, the main circuit board comprises a through-hole and the threaded fixing is received into the through-hole.

In a further embodiment of any of the above, the assembly comprises a switch-mode power supply.

According to a further aspect of the present disclosure, there is provided a sub-system for an aircraft, the sub-system comprising the circuit board assembly of any of the above.

According to a further aspect of the present disclosure, there is provided a method for manufacturing a wound core component, the method comprising the steps of forming a through-hole through a substrate layer of a carrier circuit board, attaching a wound core to the carrier circuit board, the wound core comprising a core and a wire wound around at least a portion of the core, and fixedly attaching a threaded insert for receiving a corresponding threaded fixing into the through-hole of the carrier circuit board.

In a further embodiment of the above, the method further comprises the steps of soldering the wire of the wound core to a plurality of conductive elements of the carrier circuit board, and soldering the threaded insert into attachment with a plating of the through-hole.

In a further embodiment of any of the above, the steps of soldering the wire and soldering the threaded insert are performed in a simultaneous soldering process.

These and other features of the disclosure can be best understood from the following description and drawings.

### BRIEF DESCRIPTION OF THE DRAWINGS

Figure 1 illustrates a side view of an assembly with a wound core component and a main circuit board.
Figure 2 illustrates a top view of the wound core component illustrated in Figure 1.
Figure 3 illustrates a side view of another assembly with a wound core component and a main circuit board.
Figure 4 illustrates a top view of the wound core component illustrated in Figure 3.

### DETAILED DESCRIPTION OF THE DRAWINGS

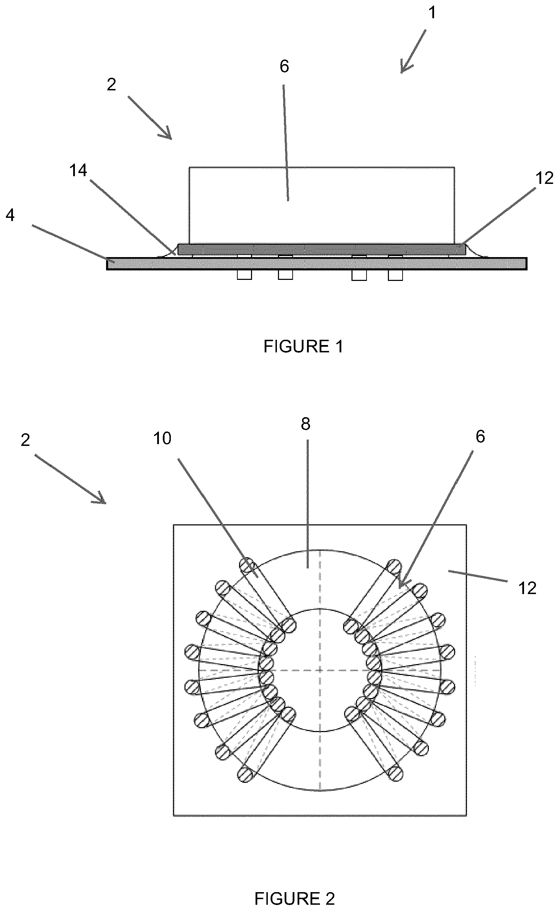

Figures 1 and 2 illustrate side and plan views of a circuit board assembly 1 with a wound core component 2 attached to a main circuit board 4. The wound core component 2 comprises a wound core 6 attached to a baseboard 12, the baseboard in turn attached to the main circuit board 4. The wound core 6 is electrically connected to the main circuit board 4.

The wound core 6 comprises a core 8 made of magnetic material and wires 10 wound around the core 8. In this example, the wound core is a toroidal wound core, with a toroidal, or donut shaped, core 8 of magnetic material. As best seen in Fig. 2, the toroidal core 8 defines a ring shape in plan view, with a toroidal body encircling a central space. A wire or wires 10 are wound around the toroidal body of the core 8, passing through the central space. In the example shown, two windings of wires 10 are provided, spaced apart around the toroidal body of the core 8.

The wound core 6 may be used as part of a circuit to be used to store or transfer electrical energy as an inductor or transformer.

The baseboard 12 of the wound core component 2 is formed of an insulating material. The wound core 6 is attached to the baseboard 12 by adhesive bonding to form the wound core component 2. Wound core components 2 constructed in this way may be used as modular components which are suitable for transporting as a piece part, for example, and which can be attached to a main circuit board 4 to form a circuit board assembly 1 for use in a specific application or system.

The wound core component 6 may be attached to a main circuit board 4 to form a circuit board assembly 1 by means of adhesive bonding. An adhesive 14 is used between the baseboard 12 to the main circuit board 4 to form an attachment which may be similar to that of the wound core 6 to the baseboard 12. Once attached to the main circuit board 4, the wound core component 2 can then be electrically connected to form part of the wider circuit.

The additional steps of applying adhesive 14 to attach the wound core 6 to the main circuit board 4 and electrically connecting the wound core may add time to the manufacturing process. The process must be performed separately to other circuit manufacturing steps, which may not require the use of adhesive. The additional process step may consume additional time in waiting for the adhesive to fully set.

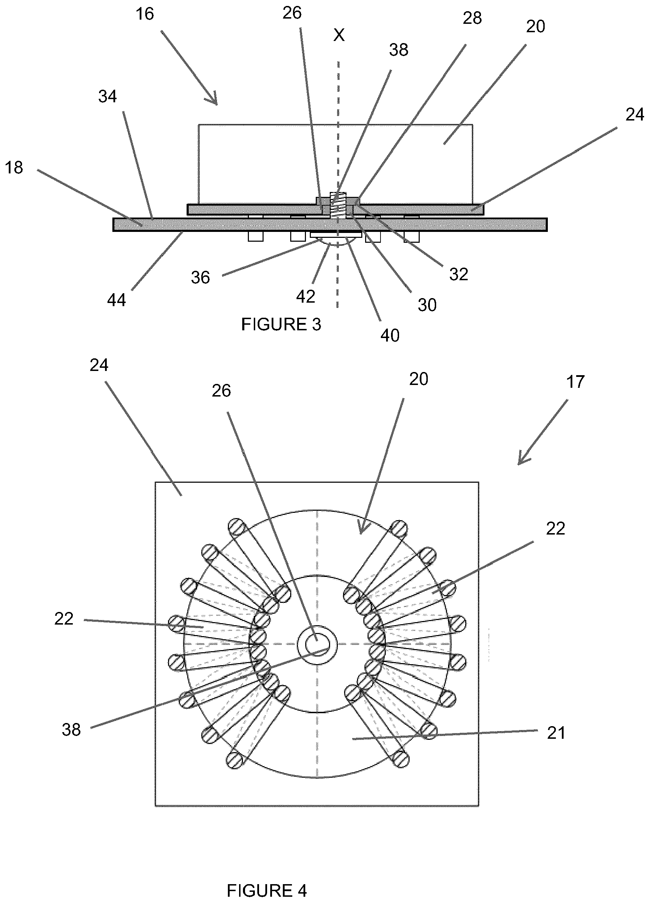

Figures 3 and 4 illustrate side and plan views of another circuit board assembly 17 with a wound core component 16 attached to a main circuit board 18. The wound core component 16 comprises a wound core 20 attached to a carrier circuit board 24. The carrier circuit board 24 is attached to the main circuit board 18 by a mechanical attachment, rather than by adhesive bonding. This mechanical attachment avoids the use of adhesive in the step of assembling the wound core component 16 to form the circuit board assembly 17.

The wound core 20 comprises a core 21 made of magnetic material and wires 22 wound around the core 21. In the illustrated example, the wound core is a toroidal wound core, with a toroidal, or donut shaped, core 21 of magnetic material. As best seen in Fig. 4, the toroidal core 21 defines a ring shape in plan view, with a toroidal body encircling a central space. A wire or wires 22 are wound around the toroidal body of the core 21, passing through the central space. In the example shown, two windings of wires 22 are used, spaced apart around the toroidal body of the core 21.

The wound core 20 is fixed to the carrier circuit board 24. The wound core 20 may be fixedly attached to the carrier circuit board 24 by adhesive bonding to form the wound core component 16, or a mechanical attachment may be used to fixedly attach the wound core 20 to the carrier circuit board 24. The wound core component 16 comprises a modular component/piece part which can be attached to the main circuit board 18.

The carrier circuit board 24 may be a printed circuit board (PCB) comprising an insulation or substrate layer, formed of relatively electrically non-conductive material, and a conductive or trace layer, formed of a relatively electrically conductive material. The carrier circuit board 24 may comprise multiple substrate and/or multiple conductive layers, for example layered in an alternating manner.

The carrier circuit board 24 provides a base for receiving the wound core 20. The substrate layer provides insulation between the wound core 20 and the main circuit board 18 to prevent electrical current from travelling from the wound core 20 to the main circuit board 18 through the substrate. The substrate layer may be in direct contact with the main circuit board 18 when the wound core component 16 is attached to form the assembly 17.

In order to be mechanically attached to the main circuit board 18, the wound core component 16 comprises a through-hole 26 formed through the carrier circuit board 24 and a threaded insert 28 secured into the through-hole 26. The threaded insert 28 has a threaded portion for receiving a corresponding threaded fixing 36 to attach the wound core component 16 in place.

The through-hole 26 formed in the carrier circuit board passes through all of the layers of the carrier circuit board 24 to extend entirely from one side to another. The through-hole 26 of the carrier circuit board 24 defines a central axis which, in the illustrated example, is co-axial with a central axis X defined by the wound core 20. The through-hole 26 may have a circular cross-section, with the threaded insert 28 correspondingly shaped to fit in the circular cross-section.

The threaded insert 28 is secured in place in the through-hole 26. In the illustrated example, the threaded insert 28 extends entirely through the through-hole 26, and past an upper surface of the carrier circuit board 24 towards the wound core component 16.

In one example, the threaded insert 28 may be secured to the through hole 26 of the carrier circuit board 24 by soldering. In this example, at least a part of the threaded insert 28 is formed of a solderable material, and the through-hole 26 of the carrier circuit board 24 is plated with a solderable material. A solderable material is one which is particularly receptive to attachment by soldering, and which forms a strong bond with solder. For example, the solderable materials of the threaded insert 28 and the plating of the through-hole 26 are more receptive to soldering attachment than the substrate layer of the carrier circuit board 24.

The threaded insert 28 comprises an annular cylindrical portion 30 and a ring-shaped flange 32 extending radially from a top end of the cylindrical portion 30. The cylindrical portion 30 extends through the through-hole 26 of the carrier circuit board 24, and the flange 32 abuts against a top surface 34 of the carrier circuit board 24. This form of the insert may provide a more robust attachment between the threaded insert 28 and the carrier circuit board 24. The flange 32 prevents the threaded insert 28 from moving relative to the carrier circuit board 24 when the threaded insert 36 is screwed into the threaded insert 28, and acts to distribute stresses across a surface of the carrier circuit board 24, avoiding stress concentrations on the solder joints of the wound core component 16.

The threaded insert 28 comprises an internally threaded hole 38 for receiving the threaded insert. The threaded hole 38 extends through the annular cylindrical portion 30 and past the flange 32 of the insert. The threaded hole 38 comprises an internal threaded portion extending along at least part of its length. The threaded portion may extend along the entire length of the threaded hole 38. In one example, the threaded portion is formed within the cylindrical portion 30 of the threaded insert 28 and at least aligned with the carrier circuit board 24, which may reduce the height profile of the wound core component 16. Forming the threaded connection partly below the surface and within a plane of the carrier circuit board 24 in this manner may leave greater space for windings of wires 22, which can lead to improved performance of the wound core 20.

The wound core component 16 is attached to the main circuit board 18 by a threaded fixing, which in the illustrated example is a threaded bolt 36. The main circuit board 18 comprises a through-hole 40 configured to receive the threaded bolt 36 therethrough. To attach the wound core component 16 to the main circuit board 18, the through hole 40 of the main circuit board 18 and the through-hole 26 of the threaded insert 28 are aligned, and the threaded bolt 36 is inserted through the through-hole 40 of main circuit board 18 and screwed into the threaded through-hole 26 of the threaded insert 28. The threaded bolt 36 has a flange 42 or head which abuts against a lower surface 44 of the main circuit board 18 such that when the threaded bolt 36 is tightened into the threaded insert 28, the wound core component 16 is secured and attached to the main circuit board 18.

In an alternative which is not illustrated, the threaded fixing may instead be a part which is formed as part of the main circuit board or is otherwise attached to the main circuit board, rather than being held in a through-hole.

Using a threaded fixing 36 and threaded insert 28 to attach a wound core component 16 to a main circuit board 18 may provide a simplified method of manufacturing a circuit assembly 17. The fixation of the wound core component 16 to the main circuit board 18 does not require specialist equipment and does not require the time-consuming use of adhesive. The use of a threaded fixing 36 and threaded insert 28 may also allow the wound core component 16 to be easily removed from the main circuit board 18, for example for maintenance or replacement of the wound core component 16.

As the threaded insert 28 is attached to the wound core component 16, the wound core component 16 may be used as a modular component which may, for example, be manufactured and transported before being attached to form part of a circuit board assembly 17. As the attachment of the wound core component 16 does not require the use of adhesive, the step of attaching the wound core component 16 to the main circuit board 18 can be performed at a facility or by a user without access to specialist equipment for applying adhesive.

Along with the mechanical attachment of the wound core component 16 to the main circuit board 18, the wound core component 16 is also electrically connected to the main circuit board 18. For example, the wound core 20 may be directly electrically connected to the main circuit board 18 after mechanical fixation by soldering wires 22 to electrical elements of the main circuit board 10.

Alternatively, the wound core 20 may instead be electrically connected to the carrier circuit board 24, to improve the ease and flexibility of electrical connection of the wound core component 16 to the main circuit board 18. The carrier circuit board 24 may comprise a plurality of conductive elements formed on the substrate layer, and the wire 22 of the wound core 20 may be electrically connected to the conductive elements, for example by soldering. The plurality of conductive elements may comprise intermediate terminals, which can be electrically connected to the main circuit board 18.

Electrically connecting the wound core 20 to the carrier circuit board 24 can form an improved wound core component 16 for attachment to the main circuit board 18. For example, where multiple wires 22 form part of the wound core (for example, to act as a transformer in a switch-mode power supply), the wire windings may be connected together on the carrier circuit board 24 as part of the wound core component 16, so that the later electrical connection of the wound core component 16 to the main circuit board 18 is simplified.

In one example, the plurality of conductive elements may be part of a trace layer of the carrier circuit board 24. The trace layer comprises copper traces printed onto the substrate layer of the carrier circuit board. Using a standard printed circuit board (PCB) with traces as a carrier circuit board can reduce the cost of manufacturing the wound core component 16 where the wire or wires 22 of the wound core 20 are connected to the traces as the conductive elements, as described above.

A method for manufacturing the assembly described above will now be described with reference to Figures 3 and 4.

The through-hole 26 is formed through the carrier circuit board 24 and, where soldering is to be used to attach the threaded insert 28, the through-hole is plated with a solderable material. The threaded insert 28 is then inserted into the through-hole 26 of the carrier circuit board 24 and secured therein.

It may be particularly advantageous to use reflow soldering to attach the threaded insert 28 into the through-hole 26. In this case, solder paste is applied between the plating of the through-hole 26 and the threaded insert 28, either before or after the threaded insert 28 is inserted into the through-hole 26. The solder paste temporarily holds the threaded insert 28 in place before a subsequent heating of the wound core component 16 results in a permanent solder join between the threaded insert 28 and the through-hole.

The wound core 20 is formed by winding wire or wires 22 around the magnetic core 21. The wound core 20 is then attached to the carrier circuit board 24, for example using adhesive.

If wires 22 of the wound core 20 are being electrically connected to the carrier circuit board 24 as described above, then solder paste may also be applied between the wires 20 and electrically conductive elements of the carrier circuit board 24, to hold the connections in place before subsequent heating to create a permanent solder join.

The wound core component 16 may then be heated, for example in a reflow oven, to heat the solder paste and create the permanent solder joins. Reflow soldering can thereby be simultaneously carried out on both the wires and the threaded insert, which can improve the ease and efficiency of the manufacturing of the wound core component 16.

The heating of the wound core component 16 for the reflow soldering may take place before the wound core component 16 is attached to a main circuit board, for example to create a wound core component 16 with robust, permanent connections for supply, transportation and/or assembly to a circuit board assembly 17.

Alternatively, the heating of the wound core component 16 for the reflow soldering may take place after attachment of the wound core component 16 is attached to the main circuit board 18, for example in a reflow soldering of the entire circuit board assembly 17. This method can increase manufacturing efficiency, because the circuit board assembly 17 generally requires heating for soldering of other parts (such as the electrical connection of the wound core component 16 to the main circuit board 18), so the reflow soldering and permanent attachment of the threaded insert 28 and connection of the wire or wires 22 can simply be incorporated into this existing manufacturing step rather than requiring a separate heating step.

In one example, the wound core component 16 and main circuit board 18 may be used in a circuit board assembly 17 forming an electronic control unit for a switch-mode power supply. In particular, the switch-mode supply may be part of an aircraft sub-system, where switch-mode power supplies are used, in part, due to their relatively small size and low weight.

In application in an aircraft sub-system, the assembly 17 may be subjected to particularly harsh mechanical environments with significant vibration levels. Using the threaded insert 28 and threaded fixing 36 can provide a more robust and reliable attachment between the wound core component 16 and the main circuit board 18 than, for example, adhesive. Securing the threaded insert 28 into the through-hole 26 of the carrier circuit board 24 provides an assembly which is particularly effective at withstanding significant vibrations when in use.

Although certain arrangements are described above by way of example, it will be appreciated that various changes and modifications can be without departing from the scope of the present application.

## Claims

1. A wound core component (16) comprising:
a wound core (20) comprising a core (21) and a wire (22) wound around at least a portion of the core (21);
a carrier circuit board (24) comprising a substrate layer and a through-hole (26) formed through the substrate layer, wherein the wound core (20) is fixed to the carrier circuit board (24); and
a threaded insert (28) for receiving a corresponding threaded fixing (36), the threaded insert (28) fixedly received into the through-hole (26) of the carrier circuit board (24).

2. The wound core component (16) of claim 1, wherein the wound core (20) is a toroidal core (21).

3. The wound core component (16) of claim 1 or 2, wherein the wound core (20) comprises an inductor or a transformer.

4. The wound core component (16) of any preceding claim, wherein the threaded insert (28) is attached to the carrier circuit board (24) by soldering.

5. The wound core component (16) of claim 4, wherein the through-hole (26) comprises a plating formed of a solderable material, and the threaded insert (28) is soldered to the plating.

6. The wound core assembly of any preceding claim, wherein the through-hole (26) defines a central axis (X) which is coaxial with a central axis (X) defined by the wound core (20).

7. The wound core component (16) of any preceding claim, wherein the carrier circuit board (24) comprises a plurality of conductive elements and the wire (22) of the wound core (20) is soldered to the plurality of conductive elements.

8. The wound core component (16) of claim 7, wherein the plurality of conductive elements comprise circuit traces of the carrier circuit board (24).

9. A circuit board assembly (17) comprising:
a main circuit board (18);
a wound core component (16) according to any preceding claim, the carrier circuit board (24) of the wound core component (16) received on the main circuit board (18); and
a threaded fixing (36) received into the threaded insert (28) to secure the wound core component (16) to the main circuit board (18).

10. The circuit board assembly (17) of claim 9, wherein the main circuit board (18) comprises a through-hole (26) and the threaded fixing (36) is received into the through-hole (26).

11. The circuit board assembly (17) of claim 9 or 10, wherein the assembly comprises a switch-mode power supply.

12. A sub-system for an aircraft, the sub-system comprising the circuit board assembly (17) of any of claims 9 to 11.

13. A method for manufacturing a wound core component (16), the method comprising the steps of:
forming a through-hole (26) through a substrate layer of a carrier circuit board (24);
attaching a wound core (20) to the carrier circuit board (24), the wound core (20) comprising a core (21) and a wire (22) wound around at least a portion of the core (21); and
fixedly attaching a threaded insert (28) for receiving a corresponding threaded fixing (36) into the through-hole (26) of the carrier circuit board (24).

14. The method of claim 13, further comprising the steps of:
soldering the wire (22) of the wound core (20) to a plurality of conductive elements of the carrier circuit board (24); and
soldering the threaded insert (28) into attachment with a plating of the through-hole (26).

15. The method of claim 14, wherein the steps of soldering the wire (22) and soldering the threaded insert (28) are performed in a simultaneous soldering process.
